# EUROPEAN PATENT APPLICATION

(11) **EP 4 471 442 A1**
(43) Date of publication of application: **04.12.2024**
(21) Application number: 24171956.6
(22) Date of filing: 23.04.2024
(51) Int. Cl.: G01R 31/389

(54) **APPARATUS AND METHOD FOR TESTING BATTERY**

(30) Priority: 31.05.2023 KR 20230070279
(71) Applicant: SK On Co., Ltd., Seoul 03161 (KR)
(72) Inventor: LEE, Kang Gu, 34124 Daejeon (KR); LEE, Jeong Hwan, 34124 Daejeon (KR); LEE, Dae Young, 34124 Daejeon (KR)
(74) Representative: Stolmár & Partner Patentanwälte PartG mbB

(57) **Abstract**

An apparatus for testing a battery includes a power unit configured to generate a charging current; a power switch connected between the power unit and a power terminal of a battery device and configured to be repeatedly in a turned-on state and a turned-off state; an insulation voltage sensing circuit connected to a chassis ground of the battery device, connected to a plus terminal or a minus terminal of a power terminal of the battery device when the power switch is in a turned-off state, and configured to sense an insulation voltage of the battery device; and a selection switch configured to connect one of a plus (+) terminal or a minus (-) terminal of the power terminal of the battery device to the insulation voltage sensing circuit when the power switch is in the turned-off state.

## Description

### TECHNICAL FIELD

The technology and implementations disclosed in this patent document generally relate to an apparatus for testing a battery, which may test charging and insulation voltage of a battery device such as a battery pack or a battery module.

### BACKGROUND

Generally, to test a charging operation of a battery module or a battery pack including a plurality of battery cells, an apparatus for testing a battery, such as a cycler, may be used.

A general apparatus for testing a battery may provide a charging test function for a battery device or a function for sensing a voltage of a battery device.

When it is necessary to test an insulation state of a battery device such as a battery module, in a general apparatus for testing a battery, a charging operation for a battery device may be temporarily suspended during the time required for the insulation state test for the battery device, and a separate insulation testing apparatus may be used for the testing.

In the general test method, the charging (or charging and discharging) operation may need to be temporarily stopped to perform a charging (or charging and discharging) test and the insulation voltage, such that there may be loss of the time and effort required for the test, which may be problematic.

### SUMMARY

Some embodiments of the disclosed technology are to provide an apparatus and a method for testing a battery, which may sense an insulation voltage for a battery device, such as a battery pack or battery module, while charging.

In some embodiments of the disclosed technology, an apparatus for testing a battery includes a power unit configured to generate a charging current; a power switch connected between the power unit and a power terminal of a battery device and configured to be repeatedly in a turned-on state and a turned-off state to switch supply of a charging current of the power unit to a power terminal of the battery device; a voltage sensing circuit connected to the battery device and configured to sense a voltage of the battery device when the power switch is in the turned-on state or the turned-off state; an insulation voltage sensing circuit connected to a chassis ground of the battery device, connected to a plus terminal or a minus terminal of a power terminal of the battery device when the power switch is in a turned-off state, and configured to sense an insulation voltage of the battery device; and a selection switch configured to connect one of a plus (+) terminal or a minus (-) terminal of the power terminal of the battery device to the insulation voltage sensing circuit when the power switch is in the turned-off state.

In some embodiments of the disclosed technology, the selection switch includes a first switch configured to connect a plus terminal of the power terminal of the battery device to one of an plus terminal of the voltage sensing circuit and a first detection terminal of the insulation voltage sensing circuit; and a second switch configured to connect a minus terminal of the power terminal of the battery device to one of a minus terminal of the voltage sensing circuit and a second detection terminal of the insulation voltage sensing circuit.

In some embodiments of the disclosed technology, the apparatus for testing a battery includes a switching control unit configured to supply a first control signal repeatedly having an on<H>level and an off<L>level to control the power switch to the turned-on state or the turned-off state, a second control signal having an on<H>level or an off<L>level to control the first switch, and a third control signal having an on<H>level or an off<L>level to control the second switch.

In some embodiments of the disclosed technology, the switching control unit includes a clock generator configured to generate a clock signal repeatedly having a high<H>level and a low<L>level; a first signal generator configured to generate a first control signal having an on<H>level or an off<L>level to control the power switch based on the clock signal; a second signal generator configured to generate a second control signal having an on<H>level or an off<L>level to control the first switch while the first control signal is at an off<L>level; and a third signal generator configured to generate a third control signal having an on<H>level or an off<L>level to control the second switch while the first control signal is at an off<L>level.

In some embodiments of the disclosed technology, the switching control unit controls a first operation mode using first, second and third control signals SC1, SC2, and SC3 having an on<H>level, high<H>level, and high<H>level.

In some embodiments of the disclosed technology, the power unit supplies the charging current to the battery device through a power switch in the turned-on state in response to the first control signal in the first operation mode, the voltage sensing circuit is connected to a power terminal of the battery device through the first switch and the second switch in response to the second and third control signals in the first operation mode, and senses a voltage of the battery device, and the insulation voltage sensing circuit is disconnected from a power terminal of the battery device in response to the second and third control signals in the first operation mode.

In some embodiments of the disclosed technology, the switching control unit controls a second operation mode using first, second and third control signals having an off<L>level, a high<H>level, and a high<H>level.

In some embodiments of the disclosed technology, the power unit is disconnected from the battery device by the power switch configured to be in the turned-off state in response to the first control signal having an off<L>level in the second operation mode, the voltage sensing circuit is connected to a power terminal of the battery device through the first switch and the second switch in response to the second and third control signals in the second operation mode, and senses a voltage of the battery device, and the insulation voltage sensing circuit is disconnected from a power terminal of the battery device in response to the second and third control signals in the second operation mode.

In some embodiments of the disclosed technology, the switching control unit controls the third operation mode using first, second and third control signals having an off<L>level, a high<H>level, and a low<L>level.

In some embodiments of the disclosed technology, the power unit is disconnected from the battery device by the power switch configured to be in a turned-off state in response to the first control signal having an off<L>level in the third operation mode, the voltage sensing circuit is disconnected from a minus terminal of the battery device in response to the third control signal having a low<L>level in the third operation mode, and the insulation voltage sensing circuit is connected to a minus terminal of the battery device through the second switch in response to the third control signal having a low<L>level in the third operation mode, and senses an insulation voltage between a minus terminal and a chassis ground of the battery device.

In some embodiments of the disclosed technology, the switching control unit controls a fourth operation mode using first, second and third control signals having an off<L>level, a low<L>level, and a high<H>level.

In some embodiments of the disclosed technology, wherein the power unit is disconnected from the battery device by the power switch configured to be in a turned-off state in response to the first control signal having an off<L>level in the fourth operation mode, the voltage sensing circuit is disconnected from a plus terminal of the battery device in response to the second control signal having a low<L>level in the fourth operation mode, and the insulation voltage sensing circuit is connected to a plus terminal of the battery device through the first switch in response to the second control signal having a low<L>level in the fourth operation mode, and senses an insulation voltage between a plus terminal of the battery device and a chassis ground.In some embodiments of the disclosed technology, a method for testing a battery implemented in an apparatus for testing a battery includes a charging operation of charging a battery device during a first time period; and an insulation voltage sensing operation of sensing an insulation voltage for the battery device during a second time period subsequent to the first time period, wherein the second time period for sensing the insulation voltage is shorter than the first time period for charging.

In some embodiments of the disclosed technology, the method includes a voltage sensing operation of sensing a voltage for the battery device during the first time period.

In some embodiments of the disclosed technology, the insulation voltage sensing operation includes a first insulation voltage sensing operation of sensing a first insulation voltage between a plus terminal of the battery device and a chassis ground of the battery device during the second time period; and a second insulation voltage sensing operation of sensing a second insulation voltage between a minus terminal of the battery device and the chassis ground during the second time period.

### BRIEF DESCRIPTION OF DRAWINGS

Certain aspects, features, and advantages of the disclosed technology are illustrated by the following detailed description with reference to the accompanying drawings.
FIG. 1 is a diagram illustrating configuration blocks of an apparatus for testing a battery according to an embodiment of disclosed technology;
FIG. 2 is a diagram illustrating configuration blocks of the apparatus for testing a battery in FIG. 1;
FIG. 3 is a diagram illustrating a first control signal, a second control signal and a third control signal;
FIG. 4 is a diagram illustrating configuration blocks of an apparatus for testing a battery according to an embodiment of disclosed technology;
FIG. 5 is a diagram illustrating configuration blocks of the apparatus for testing a battery in FIG. 4;
FIG. 6 is a diagram illustrating components of a switching control unit according to an embodiment of disclosed technology;
FIG. 7 is a diagram illustrating a first operation mode of an apparatus for testing a battery according to an embodiment of disclosed technology;
FIG. 8 is a diagram illustrating a second operation mode of an apparatus for testing a battery according to an embodiment of disclosed technology;
FIG. 9 is a diagram illustrating a first operation mode and a second operation mode using first, second, and third control signals according to an embodiment of disclosed technology;
FIG. 10 is a diagram illustrating a third operation mode of an apparatus for testing a battery according to an embodiment of disclosed technology;
FIG. 11 is a diagram illustrating a first operation mode and a third operation mode using first, second, and third control signals according to an embodiment of disclosed technology;
FIG. 12 is a diagram illustrating a fourth operation mode of an apparatus for testing a battery according to an embodiment of disclosed technology;
FIG. 13 is a diagram illustrating a first operation mode and a fourth operation mode using first, second, and third control signals according to an embodiment of disclosed technology;
FIG. 14 is a flowchart illustrating operations of a method for testing a battery according to an embodiment of disclosed technology;
FIG. 15 is a diagram illustrating a charging operation and a voltage sensing operation in FIG. 14;
FIG. 16 is a diagram illustrating an insulation voltage sensing operation according to an embodiment of disclosed technology;
FIG. 17 is a time chart diagram illustrating charging and insulation voltage sensing operations according to an embodiment of disclosed technology; and
FIG. 18 is a time chart diagram illustrating charging and insulation voltage sensing operations according to an embodiment of disclosed technology.

### DETAILED DESCRIPTION

Features of the disclosed technology disclosed in this patent document are illustrated in embodiments with reference to the accompanying drawings.

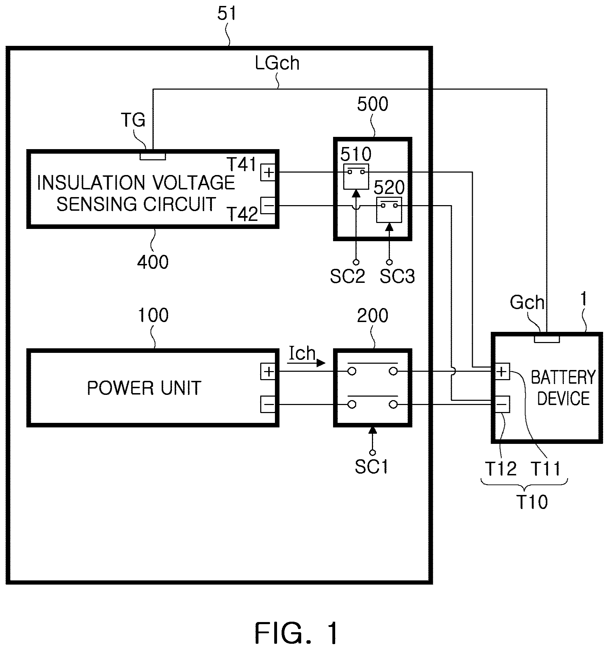

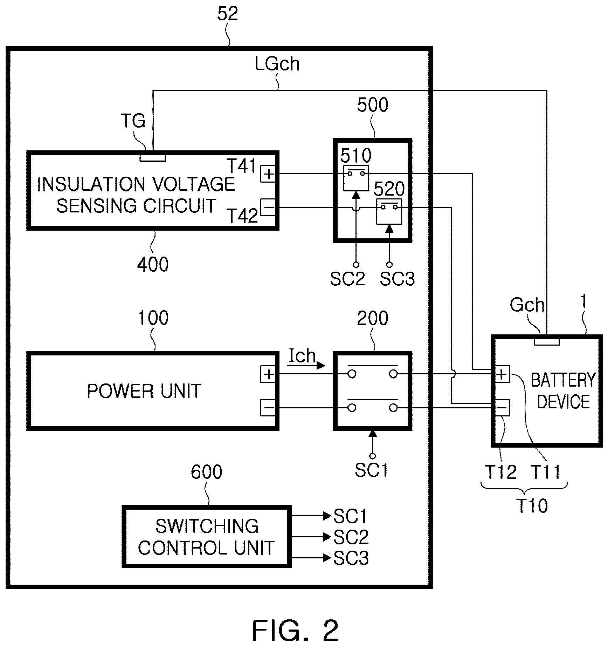

FIG. 1 is a diagram illustrating configuration blocks of an apparatus for testing a battery according to an embodiment. FIG. 2 is a diagram illustrating configuration blocks of the apparatus for testing a battery in FIG. 1.

Referring to FIG. 1, an apparatus for testing a battery 51 according to an embodiment may include a power unit 100, a power switch 200, an insulation voltage sensing circuit 400, and a selection switch 500.

Referring to FIG. 2, the apparatus 52 for testing a battery may include a power unit 100, a power switch 200, an insulation voltage sensing circuit 400, a selection switch 500, and a switching control unit 600.

Referring to FIGS. 1 and 2, the power unit 100 may generate a charging current Ich and supply the current to the power terminal T10 of the battery device 1 through the power switch 200. For example, the power unit 100 may include a circuit configured to generate charging a current Ich.

The power switch 200 may be connected between the power unit 100 and the power terminal T10 of the battery device 1, and may repeatedly have a turned-on state and a turned-off state to switch the supply of the charging current Ich of the power unit 100 to the power terminal T10 of the battery device 1. For example, the power switch 200 may be in the turned-on state or the turned-off state in response to the first control signal SC1, and may supply the charging current Ich of the power unit 100 to a power terminal T10 of the battery device 1 in the turned-on state, and may block the charging current Ich of the power unit 100 in the turned-off state.

The insulation voltage sensing circuit 400 may include a ground terminal TG connected to chassis ground GCH of the battery device 1, and detection terminals T41 and T42 connected to a plus terminal or a minus terminal of the power terminal T10 of the battery device 1 when the power switch 200 is in the turned-off state, and may sense an insulation voltage of the battery device 1. For example, when the power switch 200 is in the turned-off state and the detection terminals T41 and T42 are connected to a plus terminal of the power terminal T10 of the battery device 1, the insulation voltage sensing circuit 400 may sense an insulation voltage between the plus terminal T11 and the chassis ground GCH, and when the minus terminal of the power terminal T10 of the battery device 1 is connected, the insulation voltage sensing circuit 400 may sense the insulation voltage between a minus terminal T12 and the chassis ground GCH.

When the power switch 200 is in the turned-off state, the selection switch 500 may connect one of a plus (+) terminal T11 or a minus (-) terminal T12 of the power terminal T10 of the battery device 1 to the insulation voltage sensing circuit 400. For example, the selection switch 500 may operate switching in response to the second control signal SC2 and the third control signal SC3, such that when the power switch 200 is in the turned-off state, the plus (+) terminal T11 of the power terminal T10 of the battery device 1 may be connected to the first detection terminal T41 of the insulation voltage sensing circuit 400, or the minus (-) terminal T12 of the power terminal T10 of the battery device 1 may be connected to the second detection terminal T42 of the insulation voltage sensing circuit 400.

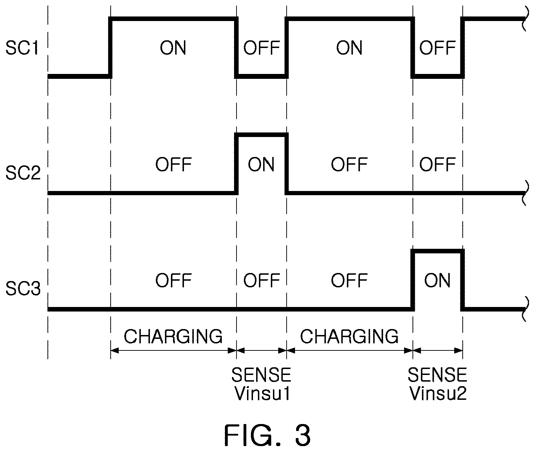

Referring to FIG. 2, the switching control unit 600 may generate the first control signal SC1 and may output the signal to the power switch 200, and may generate the second control signal SC2 and the third control signal SC3 and may output the signals to the selection switch 500, which will be described with reference to FIG. 3.

Also, referring to FIG. 2, the selection switch 500 may include a first switch 510 and a second switch 520.

The first switch 510 may be connected between the plus terminal T11 of the power terminal T10 of the battery device 1 and the first detection terminal T41 of the insulation voltage sensing circuit 400, and may switch connection between the plus terminal T11 of the power terminal T10 of the battery device 1 and the first detection terminal T41 of the insulation voltage sensing circuit 400.

For example, when the first switch 510 is in the turned-on state in response to the second control signal SC2, the plus terminal T11 of the power terminal T10 of the battery device 1 may be connected to the first detection terminal T41 of the insulation voltage sensing circuit 400. Alternatively, when the first switch 510 is in the turned-off state in response to the second control signal SC2, the plus terminal T11 of the power terminal T10 of the battery device 1 may be disconnected from the first detection terminal T41 of the insulation voltage sensing circuit 400.

The second switch 520 may switch the minus terminal T12 of the power terminal T10 of the battery device 1 and the second detection terminal T42 of the insulation voltage sensing circuit 400.

For example, when the second switch 520 is in the turned-on state in response to the third control signal SC3, the minus terminal T12 of the power terminal T10 of the battery device 1 may be connected to the second detection terminal T42 of the insulation voltage sensing circuit 400. Alternatively, when the second switch 520 is in the turned-off state in response to the third control signal SC3, the minus terminal T12 of the power terminal T10 of the battery device 1 may disconnected from the second detection terminal T42 of the insulation voltage sensing circuit 400.

In the embodiments, the battery device may be implemented as a battery unit cell, a battery module, or a battery pack. Also, the battery device may not be limited to any predetermined structure or type of a battery device, and may correspond to a battery which may require measurement of insulation voltage among rechargeable batteries.

In embodiments, the power unit 100 may be configured as a charging module for charging a battery device, or may be configured as a charging and discharging module for charging and discharging a battery device.

For each drawing of an embodiment, unnecessary descriptions of the components having the same reference numeral and the same function may not be provided, and differences between the examples in the drawings may be described.

FIG. 3 is a diagram illustrating a first control signal, a second control signal and a third control signal.

Referring to FIG. 3, the first control signal SC1 may repeatedly include an on<H>level and an off<L>level to control the power switch 200 to the turned-on state or the turned-off state.

The second control signal SC2 may include an on<H>level or an off<L>level to control the first switch 510. For example, the second control signal SC2 may have an on-level when the first control signal SC1 is at an off-level.

The third control signal SC3 may include an on<H>level or an off<L>level to control the second switch 520. For example, the third control signal SC3 may have an on-level when both the first control signal SC1 and the second control signal SC2 are at an off-level, which will described with reference to FIG. 3.

For example, the on-level and the off-level may be a high<H>level and a low<L>level, respectively, or conversely, the on-level and the off-level may be a low<L>level and a high<H>level, respectively.

In embodiments, the on-level and the off-level are described as examples for a high<H>level and a low<L>level, respectively, but this is for ease of description, and an embodiment thereof is not limited thereto.

In embodiments, <H> may represent logic high and <L> may represent logic low.

Referring to FIGS. 2 and 3, the first switch 510 may be in the turned-off state when the power switch 200 operating in response to the first control signal SC1 is in the turned-on state in response to the second control signal SC2, and the power switch 200 may be in the turned-on state when the second switch 520 operating in response to the third control signal SC3 is in the turned-off state, and in this case, the plus terminal T11 of the power terminal T10 of the battery device 1 may be connected to the first detection terminal T41 of the insulation voltage sensing circuit 400.

When the first switch 510 is in the turned-on state, the insulation voltage sensing circuit 400 may be connected to the plus terminal T11 of the power terminal T10 of the battery device 1, and may sense an insulation voltage Vinsu1 between the plus terminal T11 of the battery device 1 and the chassis ground GCH.

The second switch 520 may be in the turned-off state when the power switch 200 operating in response to the first control signal SC1 is in the turned-on state in response to the third control signal SC3, and the second switch 520 may be in the turned-on state when the power switch 200 is in the turned-off state and the first switch 520 operating in response to the second control signal SC2 is in the turned-off state. In this case, the minus terminal T12 of the power terminal T10 of the battery device 1 may be connected to the second detection terminal T42 of the insulation voltage sensing circuit 400.

When the second switch 520 is in the turned-on state, the insulation voltage sensing circuit 400 may be connected to the minus terminal of the power terminal T10 of the battery device 1, and may sense an insulation voltage Vinsu2 between the minus terminal T12 of the battery device 1 and the chassis ground GCH.

In embodiments, the sensing order of the insulation voltage Vinsu1 and the insulation voltage Vinsu2 may not be limited to any particular example.

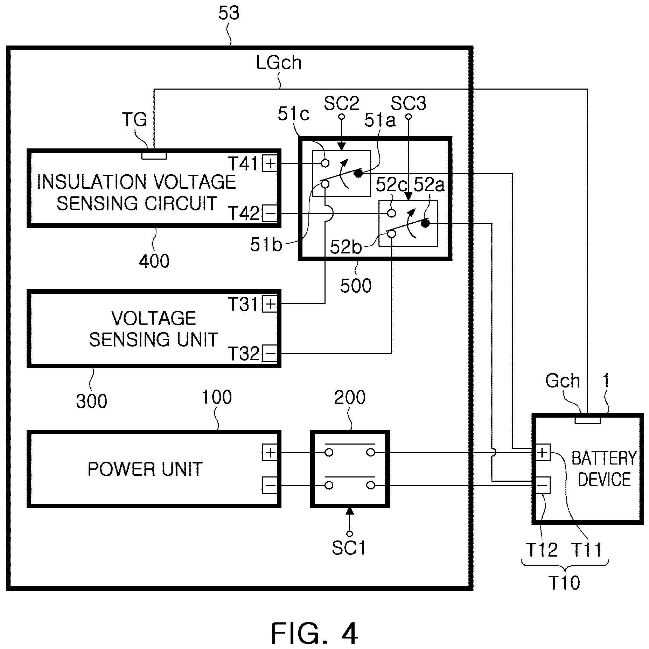

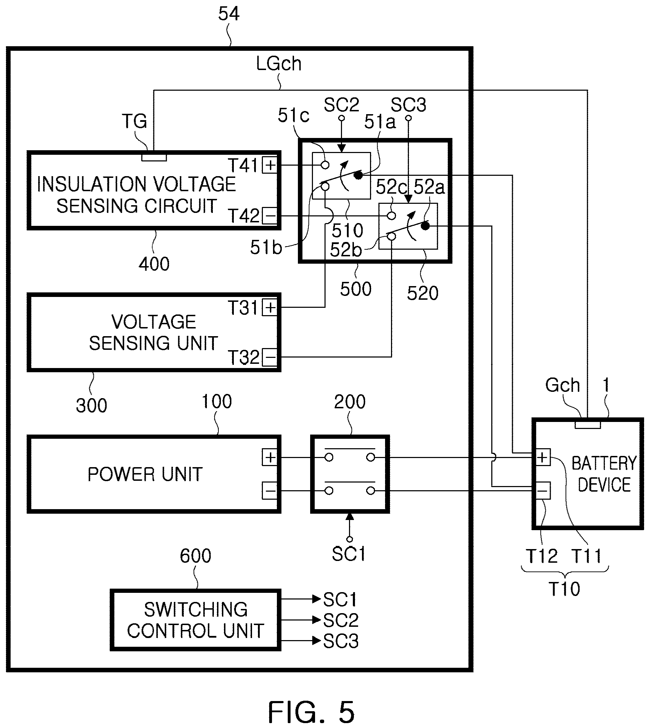

FIG. 4 is a diagram illustrating configuration blocks of an apparatus for testing a battery according to an embodiment. FIG. 5 is a diagram illustrating configuration blocks of the apparatus for testing a battery in FIG. 4.

Referring to FIG. 4, an apparatus 53 for testing a battery according to an embodiment may include a power unit 100, a power switch 200, a voltage sensing circuit 300, an insulation voltage sensing circuit 400, and a selection switch 500.

Referring to FIG. 5, the apparatus 54 for testing a battery according to an embodiment may include a power unit 100, a power switch 200, a voltage sensing circuit 300, an insulation voltage sensing circuit 400, a selection switch 500 and a switching control unit 600.

Referring to FIGS. 4 and 5, the power unit 100 may generate a charging current Ich and supply the current to the power terminal T10 of the battery device 1 through the power switch 200.

The power switch 200 may be connected between the power unit 100 and the power terminal T10 of the battery device 1, and may be repeatedly in the turned-on state and the turned-off state to switch the supply of the charging current Ich of the power unit 100 to the power terminal T10 of the battery device 1.

The voltage sensing circuit 300 may be connected to the battery device and may sense voltage of the battery device 1 when the power switch is in the turned-on state or the turned-off state. For example, when the power switch 200 is in the turned-on state or the turned-off state, detection terminals T31 and T32 of the voltage sensing circuit 300 may be connected to the power terminal T10 of the battery device 1, and may sense voltage of the battery device 1 through the power terminal T10 of the battery device 1.

The insulation voltage sensing circuit 400 may be connected to the chassis ground GCH of the battery device 1, and when the power switch 200 is in a turned-off state, the insulation voltage sensing circuit 400 may be connected to the plus terminal T11 or the minus terminal T12 of the battery device 1, and may sense the insulation voltage of the battery device 1. For example, the insulation voltage sensing circuit 400 may include a ground terminal TG connected to the chassis ground GCH of the battery device 1, a first detection terminal T41 connected to the plus terminal T11 of the battery device 1, and a second detection terminal T42 connected to the minus terminal T12 of the battery device 1. When the power switch 200 is in the turned-off state, the first detection terminal T41 may be connected to the plus terminal T11 of the power terminal T10 of the battery device 1, or the second detection terminal T42 may be connected to the minus terminal T12 of the power terminal T10, and the insulation voltage of the battery device 1 may be sensed.

When the power switch 200 is in the turned-off state, the selection switch 500 may connect one of the plus (+) terminal T11 or the minus (-) terminal T12 of the power terminal T10 of the battery device 1 to the insulation voltage sensing circuit 400.

Also, when the power switch 200 is in the turned-on state or the turned-off state, the selection switch 500 may connect the power terminal T10 of the battery device 1 to the detection terminals T31 and T32 of the voltage sensing circuit 300.

For example, the selection switch 500 may operate switching in response to the second control signal SC2 and the third control signal SC3, such that when the power switch 200 is in the turned-on state, the power terminal T10 of the battery device 1 may be connected to the detection terminals T31 and T32 of the voltage sensing circuit 300.

Alternatively, the selection switch 500 may operate switching in response to the second control signal SC2 and the third control signal SC3, such that when the power switch 200 is in the turned-off state, the plus (+) terminal of the power terminal T10 of the battery device 1 T11 may be connected to the insulation voltage sensing circuit 400, or the minus(-) terminal T12 of the power terminal T10 of the battery device 1 may be connected to the insulation voltage sensing circuit 400.

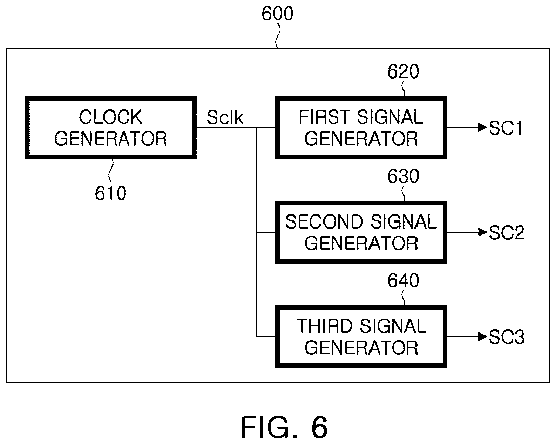

Referring to FIG. 5, the switching control unit 600 may generate the first control signal SC1 and output the signal to the power switch 200, and may generate the second control signal SC2 and the third control signal SC3 and may output the signals to the selection switch 500, which will described with reference to FIGS. 6 to 13.

Also, referring to FIG. 5, the selection switch 500 may include a first switch 510 and a second switch 520.

The first switch 510 may be connected between the plus terminal T11 of the power terminal T10 of the battery device 1 and the first detection terminal T41 of the insulation voltage sensing circuit 400 and the plus detection terminal T31 of the voltage sensing circuit 300, and may connect the plus terminal T11 of the power terminal T10 of the battery device 1 to one of the plus detection terminal T31 of the voltage sensing circuit 300 and the first detection terminal T41 of the insulation voltage sensing circuit 400 in response to the second control signal SC2.

For example, in the first switch 510, when the second control signal SC2 is at a high level, the common terminal 51a connected to the plus terminal T11 of the power terminal T10 of the battery device 1 may be connected to a first terminal 51b connected to the plus detection terminal T31 of the voltage sensing circuit 300, and when the second control signal SC2 is at a low level, the common terminal 51a connected to the plus terminal T11 of the power terminal T10 of the battery device 1 may be connected to a second terminal 51c connected to the first detection terminal T41 of the insulation voltage sensing circuit 400. The second switch 520 may be connected between the minus terminal T12 of the power terminal T10 of the battery device 1, the second detection terminal T42 of the insulation voltage sensing circuit 400, and the detection terminal T32 of the voltage sensing circuit 300, and may connect the minus terminal T12 of the power terminal T10 of the battery device 1 to one of the second detection terminal T32 of the voltage sensing circuit 300 and the second detection terminal T42 of the insulation voltage sensing circuit 400 in response to the third control signal SC3.

For example, in the second switch 520, when the third control signal SC3 is at a high level, the common terminal 52a connected to the minus terminal T12 of the power terminal T10 of the battery device 1 may be connected to the first terminal 52b connected to the second detection terminal T32 of the voltage sensing circuit 300. When the third control signal SC3 is at a low level, the common terminal 51a connected to the minus terminal T12 of the power terminal T10 of the battery device 1 may be connected to the second terminal 52c connected to the second detection terminal T42 of the insulation voltage sensing circuit 400.

As described above, the operations for the selection switch 500 illustrated in FIG. 5 may also be applied to FIGS. 4, 7, 8, 10, and 12.

In the description below, when the apparatus for testing a battery is not specifically specified or does not need to be specified, the apparatus may be configured as one of the apparatus 51, 52, 53 and 54 for testing a battery illustrated in FIGS. 1 to 5.

In embodiments, the power switch 200 and the selection switch 500 may be configured as a relay switch of contact switching method or a switch circuit using a semiconductor switch element, but are not limited to any particular form, structure, or type.

In embodiments, each of the power unit 100, the power switch 200, the voltage sensing circuit 300, the insulation voltage sensing circuit 400, the selection switch 500 and the switching control unit 600 may be implemented in hardware or software on at least one integrated circuit (IC) built into the apparatus for testing a battery, and is not limited to any particular example.

Also, each of the voltage sensing circuit 300, the insulation voltage sensing circuit 400, the selection switch 500 and the switching control unit 600 may be implemented using an individual processor or in an integrated processor, and may not be limited to any particular example.

FIG. 6 is a diagram illustrating components of a switching control unit according to an embodiment.

Referring to FIG. 6, a switching control unit 600 may include a clock generator 610, a first signal generator 620, a second signal generator 630, and a third signal generator 640.

The clock generator 610 may generate a clock signal Sclk repeatedly having a high<H>level and a low<L>level. For example, the clock signal Sclk may be configured as a signal in the form of a pulse train repeatedly having a high<H>level and a low<L>level, and in this case, a holding time of the high<H>level may be longer than a holding time of the low<L>level.

The first signal generator 620 may generate a first control signal SC1 having an on<H>level or an off<L>level to control the power switch 200 based on a clock signal Sclk. For example, the first control signal SC1 may include an on-level and an off-level synchronized with the clock signal Sclk, but an embodiment thereof is not limited thereto.

The second signal generator 630 may generate a second control signal SC2 having an on<H>level or an off<L>level to control the first switch 510 while the first control signal SC1 is at an off<L>level based on the clock signal Sclk.

The third signal generator 640 may generate a third control signal SC3 having an on<H>level or an off<L>level to control the second switch 520 while the first control signal SC1 is at the off<L>level based on the clock signal Sclk.

The first control signal SC1 may include repeated an on<H>level and an off<L>level to control the power switch 200 to the turned-on state or the turned-off state.

The second control signal SC2 may include an on<H>level or an off<L>level to control the first switch 510.

The third control signal SC3 may include an on<H>level or an off<L>level to control the second switch 520.

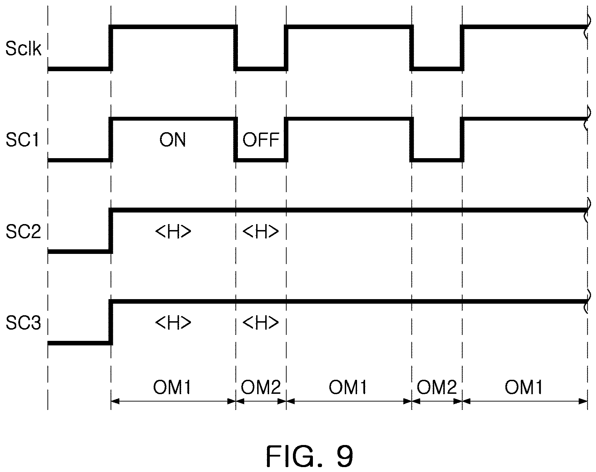

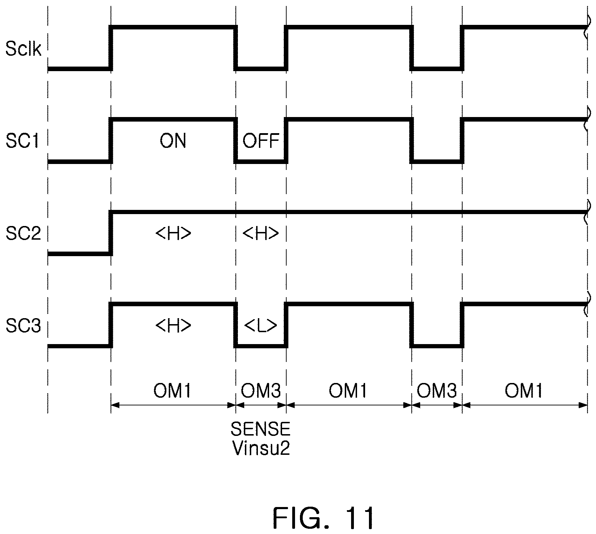

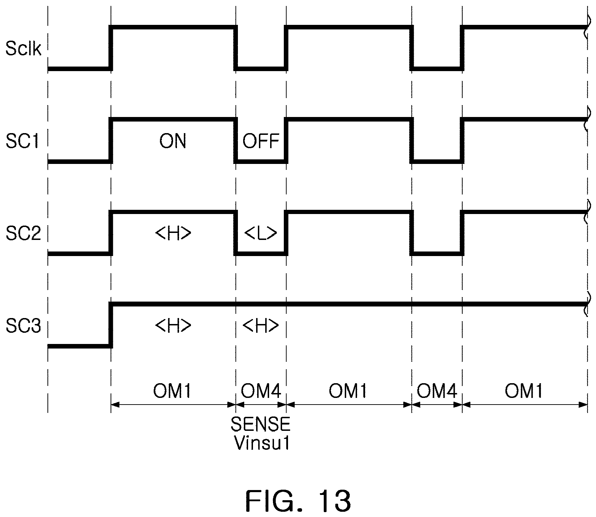

For example, in a first operationmode OM1, the first control signal SC1, the second control signal SC2, and the third control signal SC3 may be at an on-level, a high level, and a high level. In a second operation mode OM2, the first control signal SC1, the second control signal SC2, and the third control signal SC3 may be at an off-level, a high level, and a high level, respectively (see FIG. 9) . In a third operation mode OM3, the first control signal SC1, the second control signal SC2, and the third control signal SC3 may be at an off-level, a high level, and a low level, respectively (see FIG. 11). In a fourth operation mode OM4, the first control signal SC1, the second control signal SC2 and the third control signal SC3 may be at an off-level, a low level, and a high level, respectively (see FIG. 13).

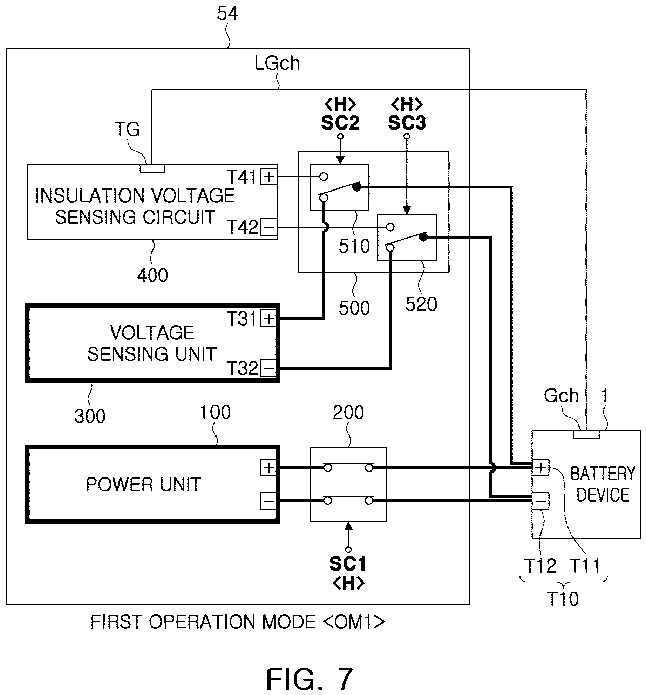

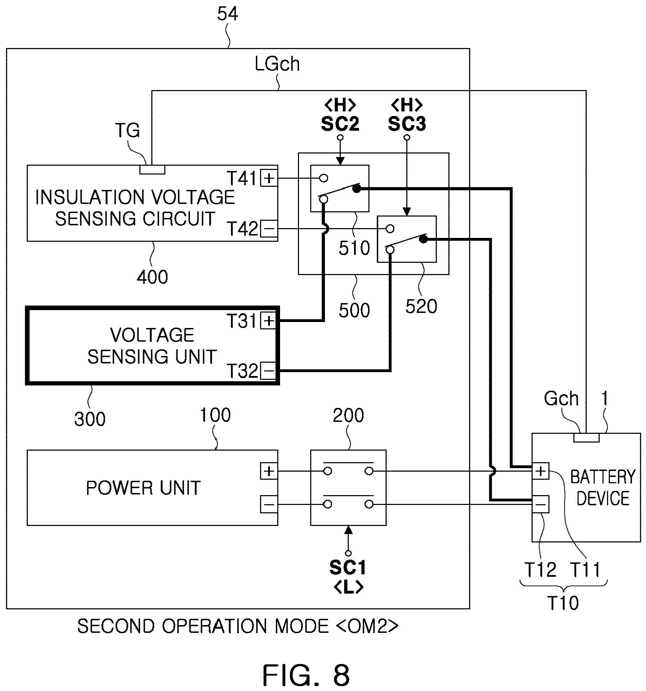

FIG. 7 is a diagram illustrating a first operation mode of an apparatus for testing a battery according to an embodiment. FIG. 8 is a diagram illustrating a second operation mode of an apparatus for testing a battery according to an embodiment. FIG. 9 is a diagram illustrating a first operation mode and a second operation mode using first, second, and third control signals according to an embodiment.

Referring to FIGS. 7 and 9, a switching control unit 600 may control a first operation mode OM1 using first, second and third control signals SC1, SC2, and SC3 having an on<H>level, a high<H>level, and a high<H>level.

The power unit 100 may supply a charging current Ich to the battery device 1 through the power switch 200 configured to be in a turned-on state in response to the first control signal SC1 having an on-level in the first operation mode OM1.

The voltage sensing circuit 300 may a connected to a power terminal T10 of a battery device 1 through a first switch 510 and a second switch 520 in the turned-on state in response to the second and third control signals SC2 and SC3 having a high level in the first operation mode OM1, and may sense voltage of the battery device 1.

For example, the plus detection terminal T31 of the voltage sensing circuit 300 may be connected to the plus terminal T11 of the power terminal T10 of the battery device 1 by the first switch 510 in response to the second control signal SC2 having a high level in the second operation mode OM2, and the minus detection terminal T32 of the voltage sensing circuit 300 may be connected to the minus terminal T12 of the power terminal T10 of the battery device 1 by the second switch 520 in response to the third control signal SC3 having a high level in the third operation mode OM3. Accordingly, the voltage sensing circuit 300 may sense voltage of the battery device 1 through the plus and minus detection terminals T31 and T32.

The insulation voltage sensing circuit 400 may be disconnected from the power terminal T10 of the battery device 1 by the first switch 510 and the second switch 520 operating in response to the second and third control signals SC2 and SC3 having a high level in the first operation mode OM1.

Referring to FIGS. 8 and 9, the switching control unit 600 may control the second operation mode OM2 using the first, second and third control signals SC1, SC2, and SC3 having an off<L>level, a high<H>level, and a high<H>level.

The power unit 100 may be disconnected from the battery device 1 by the power switch 200 configured to be in a turned-off state in response to the first control signal SC1 having an off<L>level in the second operation mode OM2. Accordingly, since the charging current output by the power unit 100 is blocked by the power switch 200 configured to be in the turned-off state, the battery device 1 may not receive a charging current and charging may not be performed.

The voltage sensing circuit 300 may be connected to the power terminal T10 of the battery device 1 through the first switch 510 and the second switch 520 configured to be in the turned-on state in response to the second and third control signals SC2 and SC3 having a high level in the second operation mode OM2, and may sense the voltage of the battery device 1. The insulation voltage sensing circuit 400 may be disconnected from the power terminal T10 of the battery device 1 in response to the second and third control signals SC2 and SC3 in the second operation mode OM1.

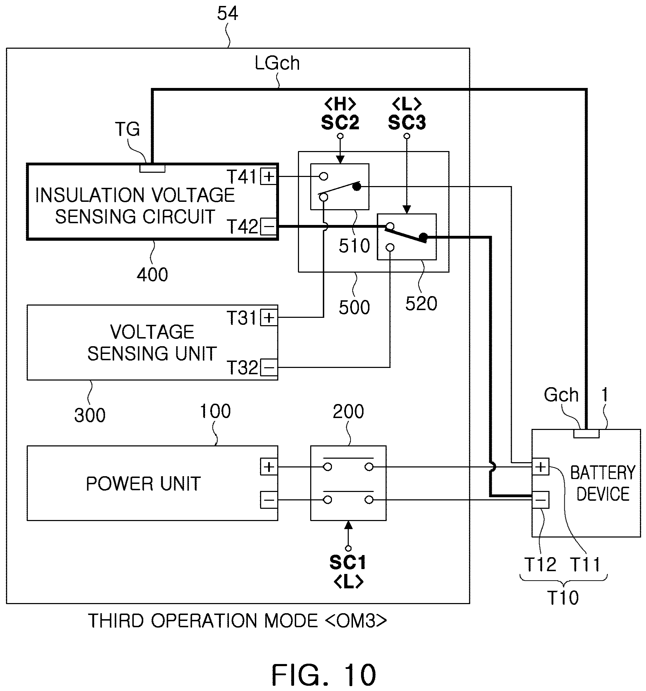

FIG. 10 is a diagram illustrating a third operation mode of an apparatus for testing a battery according to an embodiment. FIG. 11 is a diagram illustrating a first operation mode OM1 and a third operation mode OM3 using first, second, and third control signals SC1, SC2, and SC3 according to an embodiment.

Referring to FIGS. 10 and 11, the switching control unit 600 may control the third operation mode OM3 using the first, second and third control signals SC1, SC2, and SC3 having an off<L>level, a high<H>level, and a low<L>level.

The power unit 100 may be disconnected from the battery device 1 by the power switch 200 configured to be in a turned-off state in response to the first control signal SC1 having an off<L>level in the third operation mode OM3. Accordingly, the battery device 1 may not receive charging current, and charging may not be performed.

The voltage sensing circuit 300 may be disconnected from the minus terminal T12 of the battery device 1 in response to the third control signal SC3 having a low<L>level in the third operation mode OM3, and accordingly, the voltage of the battery device 1 may not be measured.

For example, the voltage sensing circuit 300 may measure voltage of the battery device 1 when the plus detection terminal T31 and the minus detection terminal T32 are connected to the plus terminal T11 and the minus terminal T12 of the battery device 1, respectively. Differently from the above example, when at least one of the plus detection terminal T31 and the minus detection terminal T32 is not connected to the plus terminal T11 and the minus terminal T12 of the battery device 1, voltage of the battery device 1 may not be measured through the plus terminal T11 and the minus terminal T12 of the battery device 1.

The insulation voltage sensing circuit 300 may be connected to the minus terminal T12 of the battery device 1 through the second switch 520 in response to the third control signal SC3 having a low<L>level in the third operation mode OM3, and may sense an insulation voltage Vinsu2 between the minus terminal T12 of the battery device 1 and a chassis ground GCH.

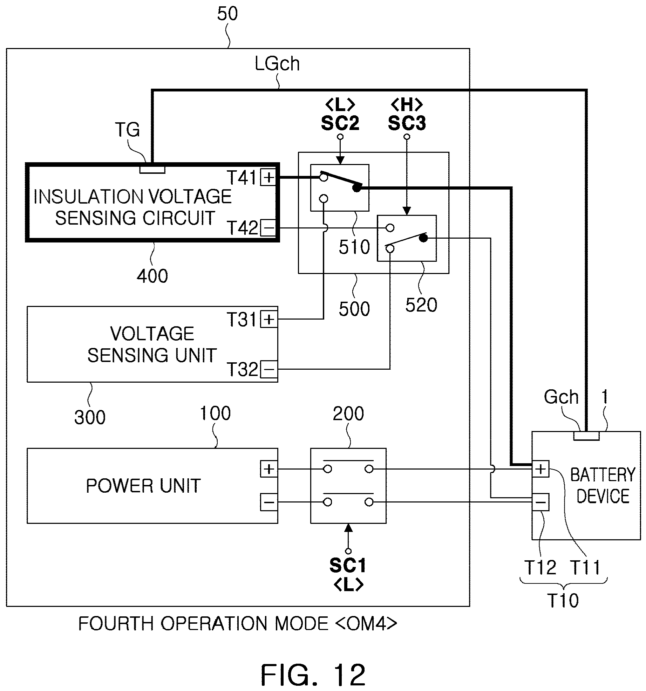

FIG. 12 is a diagram illustrating a fourth operation mode of an apparatus for testing a battery according to an embodiment. FIG. 13 is a diagram illustrating a first operation mode and a fourth operation mode using first, second, and third control signals according to an embodiment.

Referring to FIGS. 12 and 13, the switching control unit 600 may control the fourth operation mode OM4 using the first, second and third control signals SC1, SC2, and SC3 having an off<L>level, a low<L>level, and a high<H>level.

The power unit 100 may be disconnected from the battery device 1 by the power switch 200 configured to be in a turned-off state in response to the first control signal SC1 having an off<L>level in the fourth operation mode OM4. Accordingly, the battery device 1 may not receive a charging current, and charging may not be performed.

The voltage sensing circuit 300 may be disconnected from the plus terminal T11 of the battery device 1 in response to the second control signal SC2 having a low<L>level in the fourth operation mode OM3, and accordingly, the voltage of the battery device 1 may not be measured.

The insulation voltage sensing circuit 300 may be connected to an plus terminal T11 of the battery device 1 through a first switch 510 in response to the second control signal SC2 having a low<L>level in the fourth operation mode OM4, and may sense an insulation voltage Vinsu1 between the plus terminal T11 of the battery device 1 and the chassis ground GCH.

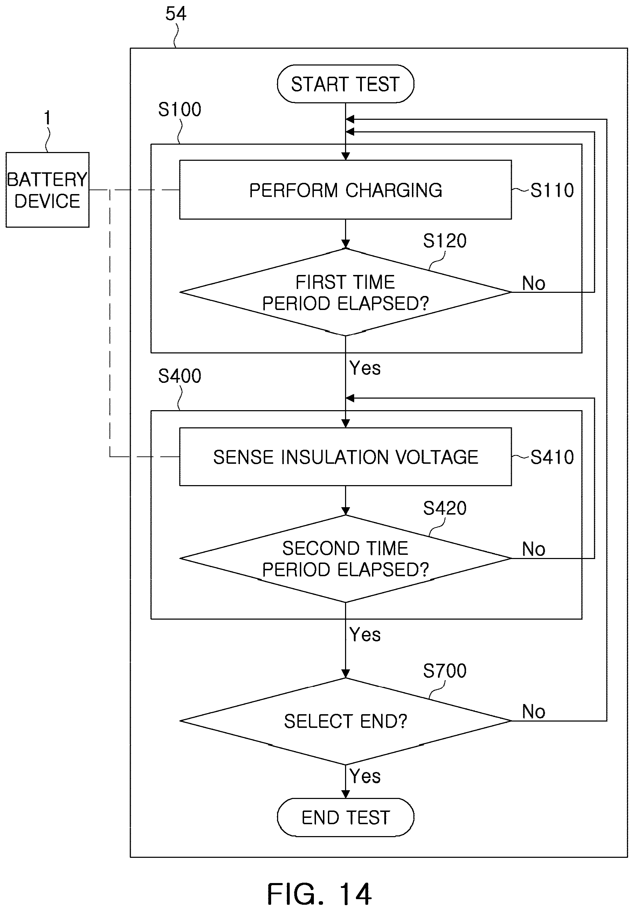

In the description below, a method for testing a battery will be described with reference to FIGS. 14, 15, 16, 17 and 18. In embodiments, the description of the method for testing a battery and the description of the apparatus for testing a battery described with reference to FIGS. 5 to 13 may applied to each other in a complementary or commonly manner, unless otherwise indicated.

FIG. 14 is a flowchart illustrating operations of a method for testing a battery according to an embodiment.

Referring to FIGS. 5 and 14, the method for testing a battery according to an embodiment may be implemented in an apparatus 54 for testing a battery.

The method for testing a battery may include charging operation (S100, S150) and insulation voltage sensing operation (S400, S450).

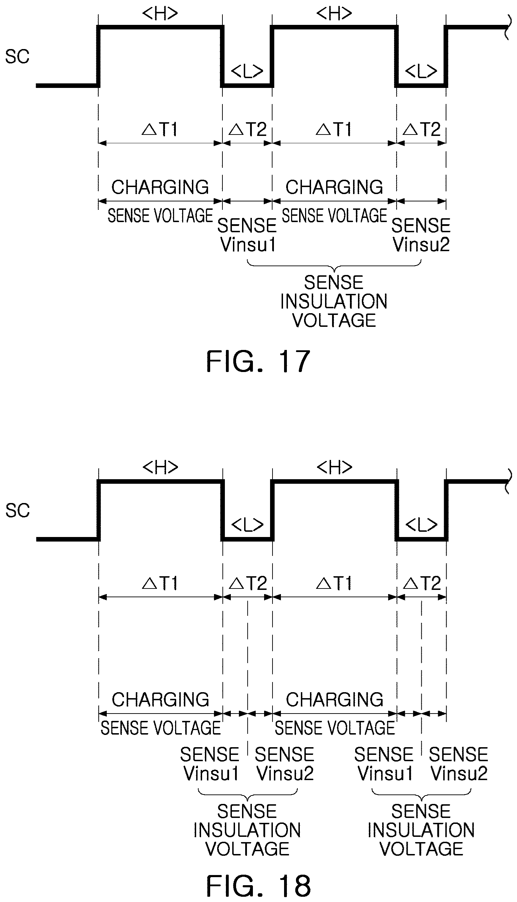

In the charging operation (S100, S150), the power unit (100 in FIG. 5) of the apparatus (54 in FIG. 5) for testing a battery may generate a charging current during a first time period (△T1 in FIG. 17), and may charge the battery device 1 by supplying the charging current.

In the insulation voltage sensing operation (S400, S450), the insulation voltage sensing circuit (300 in FIG. 5) of the apparatus (54 in FIG. 5) for testing a battery may sense an insulation voltage for the battery device 1 during a second time period (ΔT2 in FIG. 17) subsequent to the first time period (ΔT1 in FIG. 17).

In embodiments, in the method for testing a battery, while performing a charging operation on the battery device (1 in FIG. 5), to sense the insulation voltage between charging operations, the second time period ΔT2 may be shorter than the first time period △T1 for the charging. For example, the second time period ΔT2 may be simply shorter than the first time period △T1, but depending on circumstances of the battery device, the second time period ΔT2 may be shorter than half of the first time period △T1.

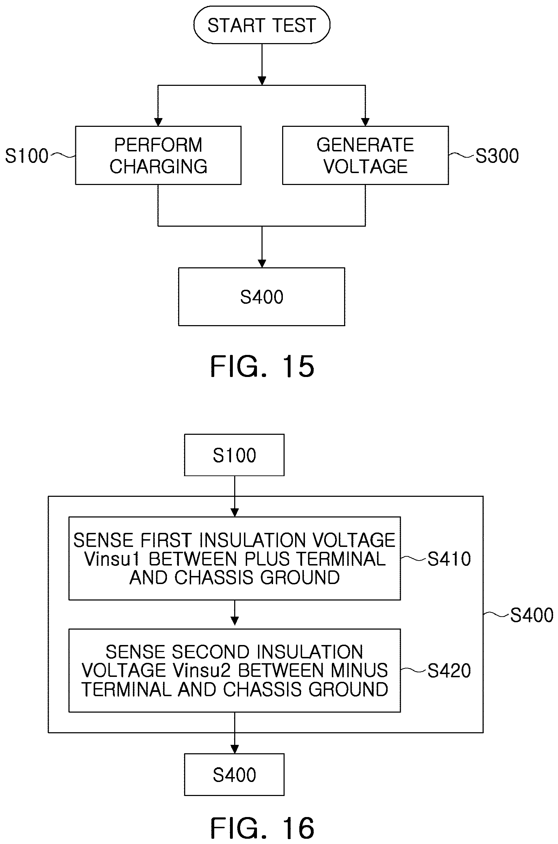

FIG. 15 is a diagram illustrating a charging operation and a voltage sensing operation in FIG. 14.

Referring to FIGS. 5, 14, and 15, the method for testing a battery may further include a voltage sensing operation (S300) performed in parallel with the charging operation (S100).

In voltage sensing operation (S300), the voltage sensing circuit (300 in FIG. 5) of the apparatus (54 in FIG. 5) for testing a battery may sense voltage for the battery device 1 during the first time period (ΔT1 in FIG. 17).

FIG. 16 is a diagram illustrating an insulation voltage sensing operation according to an embodiment.

Referring to FIG. 16, the insulation voltage sensing operation (S400) may include a first insulation voltage sensing operation (S410) and a second insulation voltage sensing operation (S420).

In the first insulation voltage sensing operation (S410), the insulation voltage sensing circuit 300 of the apparatus 54 for testing a battery may sense a first insulation voltage Vinsu1 between a plus terminal T11 of the battery device 1 and the chassis ground GCH of the battery device 1 during a second time period ΔT2.

In the second insulation voltage sensing operation (S420), the insulation voltage sensing circuit 300 of the apparatus 54 for testing a battery may sense a second insulation voltage Vinsu2 between a minus terminal T12 of the battery device 1 and the chassis ground GCH during the second time period ΔT2.

FIG. 17 is a time chart diagram illustrating charging and insulation voltage sensing operations according to an embodiment. FIG. 18 is a time chart diagram illustrating charging and insulation voltage sensing operations according to an embodiment.

Referring to FIG. 17, a sensing operation for each of a first insulation voltage Vinsu1 and a second insulation voltage Vinsu2 may be performed during a second time period ΔT2 when charging is not performed, and a first insulation voltage Vinsu1 and a second insulation voltage Vinsu2 may be sensed during different second time periods ΔT2. This is merely an example, and an embodiment thereof is not limited thereto.

Referring to FIG. 18, the sensing operation for each of the first insulation voltage Vinsu1 and second insulation voltage Vinsu2 may be performed during the second time period ΔT2 when charging is not performed, and the first insulation voltage Vinsu1 and second insulation voltage Vinsu2 may be sensed in sequence during the same second time period ΔT2. This is merely an example, and an embodiment thereof is not limited thereto.

The control signal SC illustrated in FIGS. 17 and 18 may be a signal in the form of a pulse train repeatedly having a high<H>level and a low<L>level. In this case, during the first time period △T1, which is a high<H>level of a control signal SC, a charging operation and a voltage sensing operation may be performed, and during the second time period ΔT2, which is a low<L>level, a sensing operation for sensing the insulation voltage Vinsu1 or Vinsu2 may be performed.

For example, as illustrated in FIG. 17, during each of the second time periods ΔT2, a sensing operation for sensing the first insulation voltage Vinsu1 and the second insulation voltage Vinsu2 may be performed in sequence.

Alternatively, as illustrated in FIG. 18, the sensing operation for sensing the first insulation voltage Vinsu1 and the second insulation voltage Vinsu2 may be alternately performed during different second time periods ΔT2.

According to the aforementioned embodiments, the effect of sensing the insulation voltage of the battery device while charging a battery device such as a battery pack or a battery module may be provided.

In other words, to test an insulation voltage of the battery device, the insulation voltage may be sensed without stopping a currently performed charging (or charging/discharging) operation, thereby preventing loss of the time and effort consumed for testing.

Also, when using a method of applying a high voltage of 1000 VDC or more in a general method to identify the insulation state, the method may have the issue of damage of produce as a high voltage is applied to the product for testing, but in an embodiment, since a high voltage is not used, there is no risk of loss of components due to high voltage application, which may be advantageous.

Only specific examples of implementations of certain embodiments are described. Variations, improvements and enhancements of the disclosed embodiments and other embodiments may be made with respect to the disclosure of this patent document.

## Claims

1. An apparatus for testing a battery, the apparatus comprising:
a power unit configured to generate a charging current;
a power switch connected between the power unit and a power terminal of a battery device and configured to be repeatedly in a turned-on state and a turned-off state to switch supply of a charging current of the power unit to a power terminal of the battery device;
a voltage sensing circuit connected to the battery device and configured to sense a voltage of the battery device when the power switch is in the turned-on state or the turned-off state;
an insulation voltage sensing circuit connected to a chassis ground of the battery device, connected to a plus terminal or a minus terminal of a power terminal of the battery device when the power switch is in a turned-off state, and configured to sense an insulation voltage of the battery device; and
a selection switch configured to connect one of a plus (+) terminal or a minus (-) terminal of the power terminal of the battery device to the insulation voltage sensing circuit when the power switch is in the turned-off state.

2. The apparatus of claim 1, wherein the selection switch includes:
a first switch configured to connect a plus terminal of the power terminal of the battery device to one of an plus terminal of the voltage sensing circuit and a first detection terminal of the insulation voltage sensing circuit; and
a second switch configured to connect a minus terminal of the power terminal of the battery device to one of a minus terminal of the voltage sensing circuit and a second detection terminal of the insulation voltage sensing circuit.

3. The apparatus of claim 1, further comprising:
a switching control unit configured to supply a first control signal repeatedly having an on<H>level and an off<L>level to control the power switch to the turned-on state or the turned-off state, a second control signal having an on<H>level or an off<L>level to control the first switch, and a third control signal having an on<H>level or an off<L>level to control the second switch.

4. The apparatus of claim 3, wherein the switching control unit includes:
a clock generator configured to generate a clock signal repeatedly having a high<H>level and a low<L>level;
a first signal generator configured to generate a first control signal having an on<H>level or an off<L>level to control the power switch based on the clock signal;
a second signal generator configured to generate a second control signal having an on<H>level or an off<L>level to control the first switch while the first control signal is at an off<L>level; and
a third signal generator configured to generate a third control signal having an on<H>level or an off<L>level to control the second switch while the first control signal is at an off<L>level.

5. The apparatus of claim 4, wherein the switching control unit controls a first operation mode using first, second and third control signals SC1, SC2, and SC3 having an on<H>level, high<H>level, and high<H>level.

6. The apparatus of claim 5,
wherein the power unit supplies the charging current to the battery device through a power switch in the turned-on state in response to the first control signal in the first operation mode,
wherein the voltage sensing circuit is connected to a power terminal of the battery device through the first switch and the second switch in response to the second and third control signals in the first operation mode, and senses a voltage of the battery device, and
wherein the insulation voltage sensing circuit is disconnected from a power terminal of the battery device in response to the second and third control signals in the first operation mode.

7. The apparatus of claim 4, wherein the switching control unit controls a second operation mode using first, second and third control signals having an off<L>level, a high<H>level, and a high<H>level.

8. The apparatus of claim 7,
wherein the power unit is disconnected from the battery device by the power switch configured to be in the turned-off state in response to the first control signal having an off<L>level in the second operation mode,
wherein the voltage sensing circuit is connected to a power terminal of the battery device through the first switch and the second switch in response to the second and third control signals in the second operation mode, and senses a voltage of the battery device, and
wherein the insulation voltage sensing circuit is disconnected from a power terminal of the battery device in response to the second and third control signals in the second operation mode.

9. The apparatus of claim 4, wherein the switching control unit controls the third operation mode using first, second and third control signals having an off<L>level, a high<H>level, and a low<L>level.

10. The apparatus of claim 4,
wherein the power unit is disconnected from the battery device by the power switch configured to be in a turned-off state in response to the first control signal having an off<L>level in the third operation mode,
wherein the voltage sensing circuit is disconnected from a minus terminal of the battery device in response to the third control signal having a low<L>level in the third operation mode, and
wherein the insulation voltage sensing circuit is connected to a minus terminal of the battery device through the second switch in response to the third control signal having a low<L>level in the third operation mode, and senses an insulation voltage between a minus terminal and a chassis ground of the battery device.

11. The apparatus of claim 4, wherein the switching control unit controls a fourth operation mode using first, second and third control signals having an off<L>level, a low<L>level, and a high<H>level.

12. The apparatus of claim 4,
wherein the power unit is disconnected from the battery device by the power switch configured to be in a turned-off state in response to the first control signal having an off<L>level in the fourth operation mode,
wherein the voltage sensing circuit is disconnected from a plus terminal of the battery device in response to the second control signal having a low<L>level in the fourth operation mode, and
wherein the insulation voltage sensing circuit is connected to a plus terminal of the battery device through the first switch in response to the second control signal having a low<L>level in the fourth operation mode, and senses an insulation voltage between a plus terminal of the battery device and a chassis ground.

13. A method for testing a battery implemented in an apparatus for testing a battery, the method comprising:
a charging operation of charging a battery device during a first time period; and
an insulation voltage sensing operation of sensing an insulation voltage for the battery device during a second time period subsequent to the first time period,
wherein the second time period for sensing the insulation voltage is shorter than the first time period for charging.

14. The method of claim 13, further comprising:
a voltage sensing operation of sensing a voltage for the battery device during the first time period.

15. The method of claim 13, wherein the insulation voltage sensing operation includes:
a first insulation voltage sensing operation of sensing a first insulation voltage between a plus terminal of the battery device and a chassis ground of the battery device during the second time period; and
a second insulation voltage sensing operation of sensing a second insulation voltage between a minus terminal of the battery device and the chassis ground during the second time period.
